# FASCICULE DE BREVET EUROPEEN

(11) **EP 3 473 020 B1**
(45) Date de publication et mention de la délivrance du brevet: **20.03.2024**
(21) Numéro de dépôt: 17740054.6
(22) Date de dépôt: 19.06.2017
(51) Int. Cl.: H04R 3/04, H03G 9/02, H03G 5/02, H03G 3/02

(54) **PROCEDE ET SYSTEME POUR L'OPTIMISATION DU RENDU SONORE DE BASSES FREQUENCES D'UN SIGNAL AUDIO**
VERFAHREN UND SYSTEM ZUM OPTIMIEREN DER WIEDERGABE TIEFER FREQUENZEN EINES AUDIOSIGNALS
METHOD AND SYSTEM FOR OPTIMISING THE REPROCUTION OF LOW FREQUENCIES OF AN AUDIO SIGNAL

(30) Priorité: 20.06.2016 FR 1655698
(43) Date de publication de la demande: 24.04.2019
(73) Titulaire: Arkamys, 75017 Paris (FR)
(72) Inventeur: POSTEL, François, 75020 PARIS (FR); VIDAL, Jacquemin, 91310 Leuville-sur-orge (FR)
(74) Mandataire: Ipside
(86) Numéro de dépôt international: PCT/FR2017/051599
(87) Numéro de publication internationale: WO 2017/220906

(56) Documents cités:
- EP-A1- 2 916 457
- EP-A2- 0 820 212
- US-A1- 2012 308 036

## Description

### Domaine de l'invention

La présente invention se rapporte au domaine du traitement du signal sonore.

La présente invention se rapporte plus particulièrement à un procédé et à un système pour l'optimisation du rendu sonore de basses fréquences d'un signal audio.

### Etat de la technique

On connaît dans l'état de la technique des procédés et des systèmes permettant d'améliorer le rendu sonore dans les fréquences basses.

Au sens de la présente invention, on considère comme « basses fréquences » des fréquences inférieures à 150 Hz.

On connaît dans l'état de la technique la demande internationale publiée sous le numéro WO 2013/068359 (ARKAMYS), qui se rapporte à un procédé de réduction de vibrations parasites d'un environnement d'un haut-parleur et à un dispositif de traitement associé. Cette invention de l'art antérieur concerne essentiellement un procédé de réduction de vibrations parasites d'un environnement d'un haut-parleur tout en permettant de conserver la perception de basses d'un signal électrique de son, dit signal sonore original, destiné à être diffusé après traitement par ledit haut-parleur ayant une fréquence de coupure, comportant les étapes suivantes : - identifier une bande de fréquences faisant entrer le haut-parleur en vibrations, dite bande fréquentielle vibratoire, - isoler une bande basses fréquences du signal sonore original ayant comme borne haute une fréquence proche de la fréquence de coupure du haut-parleur, - générer au moins un signal d'harmoniques à partir de la bande basses fréquences du signal sonore original isolé, - combiner le signal sonore original et le signal d'harmoniques pour obtenir un signal recombiné, - supprimer la bande fréquentielle vibratoire du signal recombiné pour obtenir un signal diffusable par le haut-parleur.

La demande de brevet européen EP 2 916 457 divulgue un système de haut-parleurs comportant une unité d'égalisation configurée pour appliquer une égalisation spécifique au signal audio en entrée du haut-parleur pour chaque niveau de volume d'une interface utilisateur.

On connaît également dans l'état de la technique des procédés consistant à faire varier le gain de manière statique, de manière à ajuster le signal audio dans les basses fréquences.

### Exposé de l'invention

La présente invention entend remédier aux inconvénients de l'art antérieur en proposant un procédé et un système pour l'optimisation du rendu sonore de basses fréquences d'un signal audio, en faisant varier de nombreux paramètres en fonction du volume d'écoute.

A cet effet, la présente invention concerne, dans son acception la plus générale, un procédé pour l'optimisation du rendu sonore de basses fréquences d'un signal audio, mettant en oeuvre des variations d'une pluralité de paramètres dudit signal audio en fonction du pas de volume dudit signal audio choisi par un utilisateur, notamment des paramètres de filtrage, de compression, des paramètres liés aux harmoniques dudit signal audio, en cherchant à optimiser la dynamique et la bande passante dudit signal audio en fonction du volume, afin de fournir un rendu optimal pour l'utilisateur.

Contrairement aux procédés et aux systèmes connus de l'état de la technique, le procédé selon la présente invention fait varier de nombreux paramètres du signal audio, ceci afin de fournir un rendu optimal pour l'utilisateur.

Dans le cadre du procédé selon la présente invention, on cherche à optimiser la dynamique et la bande passante dudit signal audio en fonction du volume, afin de fournir un rendu optimal pour l'utilisateur, à faible comme à fort volume, sans nuire à la tenue en puissance du système de reproduction dudit signal audio.

Cette pluralité de paramètres est ajustée, puis stockée par l'homme du métier, puis appelée par le système de reproduction en fonction du pas de volume choisi par l'utilisateur.

Ainsi, on renforce la dynamique à faible niveau, tout en protégeant le système de reproduction à fort niveau. Cela permet ainsi d'améliorer la dynamique du signal basses fréquences perdue lors d'une écoute à faible niveau, du fait de l'effet loudness de l'oreille humaine, tout en protégeant les haut-parleurs à fort niveau. Ce dernier point permet une amélioration du brevet précédemment cité WO 2013/068359 (ARKAMYS), en ce sens que les parasites peuvent se voir réduits à fort niveau, tout en optimisant la performance des haut-parleurs à faible niveau.

Selon un mode de réalisation, lesdits paramètres sont compris dans le groupe comportant : le taux de compression, le temps de relâchement, le temps d'attaque, le temps de retour, le seuil et la compensation de gain.

De préférence, ledit procédé comporte une étape d'ajustement des caractéristiques d'un filtre passe-haut en fonction du niveau d'entrée dudit signal audio.

La présente invention se rapporte également à un système pour l'optimisation du rendu sonore de basses fréquences d'un signal audio, comportant des moyens pour faire varier une pluralité de paramètres dudit signal audio, en fonction du pas de volume dudit signal audio choisi par un utilisateur, notamment des paramètres de filtrage, de compression, des paramètres liés aux harmoniques dudit signal audio, en cherchant à optimiser la dynamique et la bande passante dudit signal audio en fonction du volume, afin de fournir un rendu optimal pour l'utilisateur.

Avantageusement, lesdits paramètres sont compris dans le groupe comportant : le taux de compression, le temps de relâchement, le temps d'attaque, le temps de retour, le seuil et la compensation de gain.

De préférence, ledit système comporte des moyens pour ajuster les caractéristiques dudit filtre passe-haut en fonction du niveau d'entrée dudit signal audio.

### Brève description des dessins

On comprendra mieux l'invention à l'aide de la description, faite ci-après à titre purement explicatif, d'un mode de réalisation de l'invention, en référence aux Figures dans lesquelles :

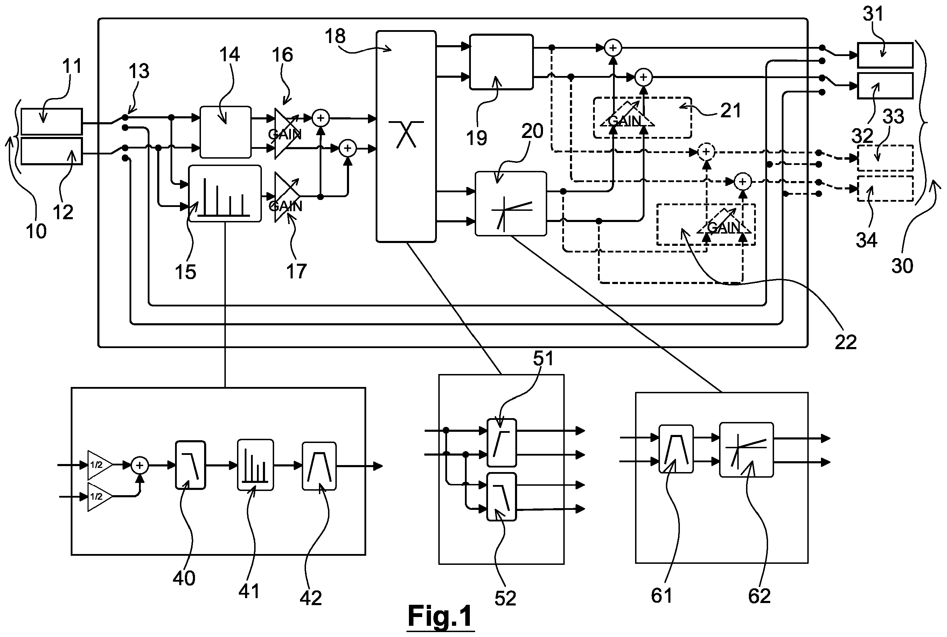

- La Figure 1 illustre le système selon la présente invention, dans un mode de réalisation.

### Description détaillée des modes de réalisation de l'invention

La présente invention se rapporte à un procédé pour l'optimisation du rendu sonore de basses fréquences d'un signal audio, mettant en oeuvre des variations d'une pluralité de paramètres P₁, P₂, P₃, ..., P_{N} dudit signal audio en fonction du pas de volume V₁, V₂, ..., V_{P} dudit signal audio choisi par un utilisateur, notamment des paramètres de filtrage, de compression, des paramètres liés aux harmoniques dudit signal audio, en cherchant à optimiser la dynamique et la bande passante dudit signal audio en fonction du volume, afin de fournir un rendu optimal pour l'utilisateur.

Contrairement aux procédés et aux systèmes connus de l'état de la technique, le procédé selon la présente invention fait varier de nombreux paramètres du signal audio, ceci afin de fournir un rendu optimal pour l'utilisateur.

Dans le cadre du procédé selon la présente invention, on cherche à optimiser la dynamique et la bande passante dudit signal audio en fonction du volume, afin de fournir un rendu optimal pour l'utilisateur, à faible comme à fort volume, sans nuire à la tenue en puissance du système de reproduction dudit signal audio.

Cette pluralité de paramètres est ajustée, puis stockée par l'homme du métier, puis appelée par le système de reproduction en fonction du pas de volume choisi par l'utilisateur.

Ainsi, on renforce la dynamique à faible niveau, tout en protégeant le système de reproduction à fort niveau.

Par exemple, pour une variation de volume allant de 0 (volume minimum = -100 dB d'atténuation) à 30 (volume maximal = 0 dB d'atténuation), on considère ici sept étapes d'ajustements des paramètres des éléments de la Figure 1. Les paramètres intermédiaires sont ici interpolés.

En référence à la Figure 1, on a le tableau suivant :

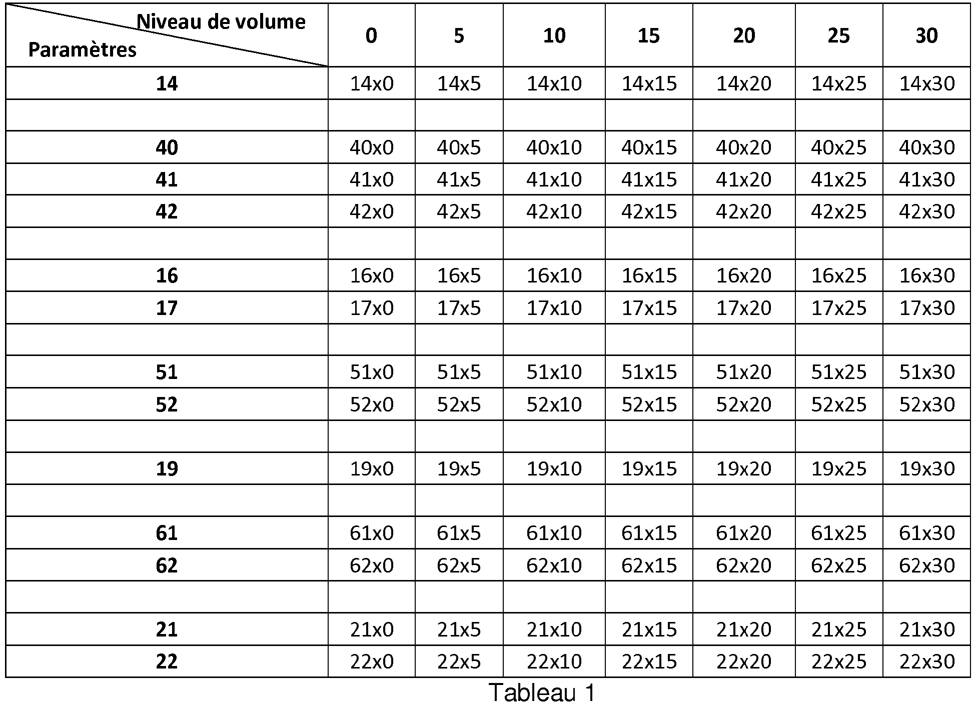

On notera que les paramètres mentionnés en colonne gauche du Tableau 1 ci-dessus correspondent aux blocs représentés sur la Figure 1.

Si l'on considère trente étapes d'ajustements, alors à chaque pas de volume correspond une pluralité de paramètres (14x0, 14x1, 14x2, 14x3, etc.).

Dans un mode de réalisation, lesdits paramètres P₁, P₂, P₃, ..., P_{N} sont compris dans le groupe comportant : le taux de compression, le temps de relâchement, le temps d'attaque, le temps de retour, le seuil et la compensation de gain.

Dans un mode de réalisation, ledit procédé comporte une étape d'ajustement des caractéristiques dudit filtre passe-haut F en fonction du niveau d'entrée dudit signal audio.

La présente invention se rapporte également à un système pour l'optimisation du rendu sonore de basses fréquences d'un signal audio, comportant des moyens pour faire varier une pluralité de paramètres P₁, P₂, P₃, ..., P_{N} dudit signal audio, en fonction du pas de volume V₁, V₂, ..., V_{P} dudit signal audio choisi par un utilisateur, notamment des paramètres de filtrage, de compression, des paramètres liés aux harmoniques dudit signal audio, en cherchant à optimiser la dynamique et la bande passante dudit signal audio en fonction du volume, afin de fournir un rendu optimal pour l'utilisateur.

Dans un mode de réalisation, lesdits paramètres P₁, P₂, P₃, ..., P_{N} sont compris dans le groupe comportant : le taux de compression, le temps de relâchement, le temps d'attaque, le temps de retour, le seuil et la compensation de gain.

Dans un mode de réalisation, ledit système comporte des moyens pour ajuster les caractéristiques dudit filtre passe-haut F en fonction du niveau d'entrée dudit signal audio.

La Figure 1 illustre le système selon la présente invention, dans un mode de réalisation.

On observe en Figure 1 que le système selon la présente invention comporte un signal d'entrée 10 et un signal de sortie 30.

Le signal d'entrée 10 est composé d'un canal gauche 11 et d'un canal droit 12.

Le signal de sortie 30 est composé d'un canal avant gauche 31, d'un canal avant droit 32, d'un canal arrière gauche 33 et d'un canal arrière droit 34.

Le système selon la présente invention comporte un élément dit élément de « *by-pass »* 13, un module de retard 14 et un harmoniseur 15.

Le système selon la présente invention comporte deux modules de gain : un module dit module de « *dry gain »* 16 et un module dit module de « *wet gain »* 17.

Le système selon la présente invention comporte également un module dit module de « *crossover »* 18, un second module de retard 19 et un bloc de compression 20.

Enfin, ledit système selon la présente invention comporte deux autres modules de gain, un module de gain avant de basse 21, et un module arrière de basse 22, ceci avant la sortie.

L'harmoniseur 15 est composé :
- d'un filtre pré-harmoniques 40 de type IIR (« *Infinite Impulse Response »* en terminologie anglo-saxonne), constitué dans un exemple de réalisation de deux filtres passe-bas bi-quads identiques ;
- d'un générateur d'harmoniques 41 (si le signal d'entrée dans ce module est négatif, alors le signal de sortie de ce module est nul) ; et
- d'un filtre post-harmoniques 42 de type IIR (« *Infinite Impulse Response »* en terminologie anglo-saxonne), constitué dans un exemple de réalisation d'un filtre passe-haut bi-quad et de deux filtres passe-bas bi-quads identiques.

Le module dit module de « *crossover »* 18 est composé :
- d'un sous-module dit module de « *crossover high »* 51 : un filtre de type IIR (« *Infinite Impulse Response »* en terminologie anglo-saxonne), constitué dans un exemple de réalisation de deux filtres passe-haut bi-quads identiques ; et
- d'un sous-module dit module de « *crossover low »* 52 : 51 : un filtre de type IIR (« *Infinite Impulse Response »* en terminologie anglo-saxonne), constitué dans un exemple de réalisation de deux filtres passe-bas bi-quads identiques.

Ledit bloc de compression 20 est composé :
- d'un sous-module 61 dit « *speaker cut »* constitué d'un filtre bi-quad ; et
- d'un autre sous-module 62, qui est un compresseur stéréo, comportant des paramètres ajustables comme le seuil, la pente de compression, la pente d'expansion, le temps d'attaque, le temps de relâchement et la compensation de gain.

L'invention est décrite dans ce qui précède à titre d'exemple. Il est entendu que l'homme du métier est à même de réaliser différentes variantes de l'invention sans pour autant sortir du cadre du brevet.

## Revendications

1. Système pour l'optimisation du rendu sonore de basses fréquences d'un signal composé d'un canal gauche (11) et d'un canal droit (12), comportant des moyens pour faire varier une pluralité de paramètres (P₁, P₂, P₃, ..., P_{N}) dudit signal audio, en fonction du pas de volume (V₁, V₂, ..., V_{P}) dudit signal audio choisi par un utilisateur, notamment des paramètres de filtrage, de compression, des paramètres liés aux harmoniques dudit signal audio, en cherchant à optimiser la dynamique et la bande passante dudit signal audio en fonction du volume, afin de fournir un rendu optimal pour l'utilisateur, lesdits moyens pour faire varier une pluralité de paramètres (P₁, P₂, P₃, ..., P_{N}) dudit signal audio comportant :
- un premier module de retard (14) recevant en entrée le signal audio ;
- un harmoniseur (15) recevant en entrée le signal audio et comportant un filtre pré-harmoniques (40) de type IIR connecté à un générateur d'harmoniques (41) connecté à un filtre post-harmoniques (42) de type IIR ;
- un module de dry gain (16) en sortie du module de retard (14) ;
- un module de wet gain (17) en sortie de l'harmoniseur (15) ;
- un module de crossover (18) recevant en entrée une combinaison des sorties des modules de dry gain (16) et wet gain (17), ledit module de crossover (18) étant composé d'un sous-module dit module de « crossover high » (51) de type IIR et d'un sous-module dit module de « crossover low » (52) de type IIR ;
- un second module de retard (19) en sortie du module de crossover (18) ;
- un bloc de compression (20) en sortie du module de crossover (18), ledit bloc de compression comportant un sous-module (61) dit speaker eut, constitué d'un filtre bi-quad et un compresseur stéréo (62) comportant des paramètres ajustables comme le seuil, la pente de compression, la pente d'expansion, le temps d'attaque, le temps de relâchement et la compensation de gain ;
- un module de gain avant basse (21) en sortie du bloc de compression (20) ;
- un module de gain arrière de basse (22) en sortie du bloc de compression (20) et en ce qu'un signal de sortie (30) est composé d'un canal avant gauche (31) et d'un canal avant droit (32) correspondant à une combinaison des signaux en sortie du module de gain avant basse (21) et du second module de retard (19), et d'un canal arrière gauche (33) et d'un canal arrière droit (34) correspondant à une combinaison des signaux en sortie du module de gain arrière basse (22) du second module de retard (19).

2. Système pour l'optimisation du rendu sonore de basses fréquences d'un signal audio selon la revendication 1, **caractérisé en ce que** lesdits paramètres (P₁, P₂, P₃, ..., P_{N}) sont compris dans le groupe comportant : le taux de compression, le temps de relâchement, le temps d'attaque, le temps de retour, le seuil et la compensation de gain.

3. Système pour l'optimisation du rendu sonore de basses fréquences d'un signal audio selon la revendication 1 ou 2, **caractérisé en ce qu'**il comporte des moyens pour ajuster les caractéristiques d'un filtre passe-haut (F) en fonction du niveau d'entrée dudit signal audio.

## Patentansprüche

1. System zum Optimieren der niederfrequenten Klangwiedergabe eines Signals, das aus einem linken Kanal (11) und einem rechten Kanal (12) besteht, umfassend Mittel zum Variieren einer Vielzahl von Parametern (P₁, P₂, P₃, ..., P_{N}) des Audiosignals entsprechend dem Lautstärkepegel (V₁, V₂, ..., V_{P}) des Audiosignals, der von einem Benutzer gewählt wird, insbesondere Filterparameter, Komprimierungsparameter, Parameter, die mit den Harmonischen des Audiosignals verbunden sind, um die Dynamik und die Bandbreite des Audiosignals entsprechend dem Lautstärkepegel zu optimieren, um eine optimale Wiedergabe für den Benutzer bereitzustellen, wobei die Mittel zum Variieren einer Vielzahl von Parametern (P₁, P₂, P₃, ..., P_{N}) des Audiosignals Folgendes umfassen:
- ein erstes Verzögerungsmodul (14), das das Audiosignal am Eingang empfängt;
- einen Harmonisierer (15), der das Audiosignal am Eingang empfängt und ein vorharmonisches Filter (40) vom IIR-Typ umfasst, das mit einem Oberwellengenerator (41) verbunden ist, der mit einem nachharmonischen Filter (42) vom IIR-Typ verbunden ist;
- ein Dry-Gain-Modul (16) am Ausgang des Verzögerungsmoduls (14);
- ein Wet-Gain-Modul (17) am Ausgang des Harmonisierers (15) ;
- ein Crossover-Modul (18), das am Eingang eine Kombination der Ausgänge des Dry-Gain- (16) und des Wet-Gain-Moduls (17) empfängt, wobei das Crossover-Modul (18) aus einem Untermodul, das sogenannte "Crossover High"-Modul (51) vom IIR-Typ, und einem Untermodul, das sogenannte "Crossover Low"-Modul (52) vom IIR-Typ, besteht;
- ein zweites Verzögerungsmodul (19) am Ausgang des Crossover-Moduls (18);
- einen Komprimierungsblock (20) am Ausgang des Crossover-Moduls (18), wobei der Komprimierungsblock ein Untermodul (61), das sogenannte Speaker-Cut, umfasst, das aus einem Biquad-Filter und einem Stereokompressor (62) mit einstellbaren Parametern wie dem Schwellenwert, dem Komprimierungsanstieg, dem Expansionsanstieg, der Attack-Zeit, der Release-Zeit und der Verstärkungskompensation;
- ein vorderes Bassverstärkungsmodul (21) am Ausgang des Komprimierungsblocks (20);
- ein hinteres Bassverstärkungsmodul (22) am Ausgang des Komprimierungsblocks (20);
und dadurch, dass ein Ausgangssignal (30) aus einem vorderen linken Kanal (31) und einem vorderen rechten Kanal (32), die einer Kombination der Signale am Ausgang des vorderen Bassverstärkungsmoduls (21) und des zweiten Verzögerungsmoduls (19) entsprechen, und aus einem hinteren linken Kanal (33) und einem hinteren rechten Kanal (34) besteht, die einer Kombination der Signale am Ausgang des hinteren Bassverstärkungsmoduls (22) des zweiten Verzögerungsmoduls (19) entsprechen.

2. System zum Optimieren der niederfrequenten Klangwiedergabe eines Audiosignals nach Anspruch 1, **dadurch gekennzeichnet, dass** die Parameter (P₁, P₂, P₃, ..., P_{N}) in der Gruppe enthalten sind, die aus Folgendem besteht: der Komprimierungsrate, der Release-Zeit, der Attack-Zeit, der Wiederherstellungszeit, dem Schwellenwert und der Verstärkungskompensation.

3. System zum Optimieren der niederfrequenten Klangwiedergabe eines Audiosignals nach Anspruch 1 oder 2, **dadurch gekennzeichnet, dass** es Mittel zum Anpassen der Eigenschaften eines Hochpassfilters (F) entsprechend dem Eingangspegel des Audiosignals umfasst.

## Claims

1. System for optimising the sound rendition of low frequencies of a signal composed of a left-hand channel (11) and a right-hand channel (12), including means for varying a plurality of parameters (P₁, P₂, P₃, ... P_{N}) of said audio signal, according to the volume pitch (V₁, V₂, ..., V_{P}) of said audio signal selected by a user, in particular filtering and compression parameters and parameters related to the harmonics of said audio signal, by seeking to optimise the dynamic range and the bandwidth of said audio signal according to the volume, in order to provide an optimum rendition for the user, said means for varying a plurality of parameters (P₁, P₂, P₃, ... P_{N}) of said audio signal including:
- a first delay module (14) receiving the audio signal as an input;
- a harmoniser (15) receiving the audio signal as an input and including a pre-harmonics filter (40) of the IIR type connected to a harmonics generator (41) connected to a post-harmonics filter (42) of the IIR type;
- a dry-gain module (16) at the output of the delay module (14);
- a wet-gain module (17) at the output of the harmoniser (15) ;
- a crossover module (18) receiving as an input a combination of the outputs of the dry-gain (16) and wet-gain (17) modules, said crossover module (18) being composed of a submodule known as a "crossover high" module (51) of the IIR type and a submodule known as a "crossover low" module (52) of the IIR type;
- a second delay module (19) at the output of the crossover module (18);
- a compression block (20) at the output of the crossover module (18), said compression block including a so-called speaker cut submodule (61), consisting of a bi-quad filter and a stereo compressor (62) having adjustable parameters such as the threshold, the compression slope, the expansion slope, the attack time, the release time and the gain compensation;
- a bass front gain module (21) at the output of the compression block (20);
- a bass rear gain module (22) at the output of the compression block (20);
and in that an output signal (30) is composed of a left front channel (31) and a right front channel (32) corresponding to a combination of the output signals of the bass front gain module (21) and of the second delay module (19), and a left rear channel (33) and a right rear channel (34) corresponding to a combination of the output signals of the bass rear gain module (22) of the second delay module (19).

2. System for optimising the sound rendition of low frequencies of an audio signal according to claim 1, **characterised in that** said parameters (P₁, P₂, P₃, ... P_{N}) are included in the group including: the compression ratio, the release time, the attack time, the return time, the threshold and the gain compensation.

3. System for optimising the sound rendition of low frequencies of an audio signal according to claim 1 or 2, **characterised in that** it includes means for adjusting the characteristics of a high-pass filter (F) according to the input level of said audio signal.
